# EUROPEAN PATENT APPLICATION

(11) **EP 4 783 229 A1**
(43) Date of publication of application: **29.07.2026**
(21) Application number: 24868174.4
(22) Date of filing: 10.09.2024
(51) Int. Cl.: H01L 21/304, B32B 27/30, H01L 21/306

(54) **SUBSTRATE PROCESSING DEVICE**

(30) Priority: 22.09.2023 JP 2023158164; 10.07.2024 JP 2024110865
(71) Applicant: SCREEN Holdings Co., Ltd., Kyoto-shi, Kyoto 602-8585 (JP)
(72) Inventor: OKA, Shogo, Kyoto-shi, Kyoto 602-8585 (JP); MORI, Ryohei, Kyoto-shi, Kyoto 602-8585 (JP); FUJIKAWA, Yuhei, Kyoto-shi, Kyoto 602-8585 (JP); MORITA, Tomokazu, Kyoto-shi, Kyoto 602-8585 (JP); OSADA, Naoyuki, Kyoto-shi, Kyoto 602-8585 (JP)
(74) Representative: Kilian Kilian & Partner mbB
(86) International application number: PCT/JP2024/032432
(87) International publication number: WO 2025/063097

(57) **Abstract**

A substrate processing apparatus processes substrates. The substrate processing apparatus includes a plurality of pipings that make a fluid flow. The plurality of pipings include at least one inner virgin material piping. The inner virgin material piping has an inner layer and an outer layer. The inner layer contains a virgin material of fluororesin. The outer layer is formed on an outer side of the inner layer. The outer layer contains a recycled material of fluororesin. The fluid flows on an inner side of the inner layer.

## Description

### Technical Field

The present invention relates to a substrate processing apparatus.

### Description of Related Art

The substrate processing apparatus includes a piping that makes a processing liquid flow and a piping that makes a gas flow. A fluororesin molded product is used for the piping that makes the processing liquid flow (see, for example, Patent Literature 1). The fluororesin molded product is used for a piping that is included in the piping that makes the gas flow and that is disposed under a chemical liquid atmosphere.

### Citation List

### Patent Literature

Patent Literature 1: Japanese Patent Application Publication No. 2020-155649

### Summary of Invention

### Technical Problem

However, saving environmental resources has been demanded more stringently than before. Since raw materials for fluororesins are natural materials and the amount of resources thereof is finite, saving of the raw materials for fluororesins (environmental resources) is also demanded.

The present invention has been made in view of the above problems, and an object of the present invention is to provide a substrate processing apparatus capable of saving environmental resources.

### Solution to Problem

According to one aspect of the present invention, a substrate processing apparatus processes a substrate. The substrate processing apparatus includes a plurality of pipings that make a fluid flow. The plurality of pipings include at least one inner virgin material piping. The inner virgin material piping has an inner layer and an outer layer. The inner layer contains a virgin material of fluororesin. The outer layer is formed on an outer side of the inner layer. The outer layer contains a recycled material of fluororesin. The fluid flows on an inner side of the inner layer.

In a preferred embodiment, the substrate processing apparatus further includes a substrate processing portion that executes substrate processing on the substrate. The substrate processing portion has a chamber that houses the substrate. The plurality of pipings include an extra-chamber piping. The extra-chamber piping is disposed outside the chamber. The extra-chamber piping makes the fluid to be supplied to the substrate processing portion flow. The extra-chamber piping includes the inner virgin material piping.

In a preferred embodiment, the substrate processing apparatus further includes a nozzle. The nozzle is disposed inside the chamber. The nozzle discharges the fluid in the chamber. The plurality of pipings include an intra-chamber supply piping. The intra-chamber supply piping is disposed inside the chamber. The intra-chamber supply piping makes the fluid to be supplied to the nozzle flow. The intra-chamber supply piping includes a virgin material piping. At least an inner surface and an outer surface of the virgin material piping are constituted of a virgin material of fluororesin.

In a preferred embodiment, the substrate processing apparatus further includes a substrate processing portion and a fluid cabinet. The substrate processing portion executes substrate processing on the substrate. The fluid cabinet houses a liquid to be supplied to the substrate processing portion. The substrate processing portion has a chamber that houses the substrate. The plurality of pipings include a recovery piping. The liquid expelled from the substrate processing portion is recovered to the fluid cabinet by the recovery piping. The recovery piping includes an extra-chamber recovery piping that is disposed outside the chamber. The extra-chamber recovery piping includes the inner virgin material piping.

In a preferred embodiment, the recovery piping includes an intra-chamber recovery piping that is disposed inside the chamber. The intra-chamber recovery piping includes a virgin material piping. At least an inner surface and an outer surface of the virgin material piping are constituted of a virgin material of fluororesin.

In a preferred embodiment, the inner virgin material piping further has a barrier layer that is formed between the inner layer and the outer layer.

In a preferred embodiment, a thickness of the inner layer is less than a thickness of the outer layer.

In a preferred embodiment, coloring is performed on the inner virgin material piping.

In a preferred embodiment, the plurality of pipings include a virgin material piping at least an inner surface and an outer surface of which are constituted of a virgin material of fluororesin, and the virgin material piping is different in color from the inner virgin material piping.

According to another aspect of the present invention, a substrate processing apparatus processes a substrate. The substrate processing apparatus includes a plurality of pipings that make a fluid flow. The plurality of pipings include at least one inner recycled material piping. The inner recycled material piping has an inner layer and an outer layer. The inner layer contains a recycled material of fluororesin. The outer layer is formed on an outer side of the inner layer. The outer layer contains a virgin material of fluororesin. The fluid flows on an inner side of the inner layer.

In a preferred embodiment, the substrate processing apparatus further includes a substrate processing portion that executes substrate processing on the substrate. The substrate processing portion has a chamber that houses the substrate. The plurality of pipings include a drain piping that makes the fluid expelled from the substrate processing portion. The drain piping includes an intra-chamber drain piping that is disposed inside the chamber. The intra-chamber drain piping includes the inner recycled material piping.

In a preferred embodiment, the drain piping includes an extra-chamber drain piping that is disposed outside the chamber. The extra-chamber drain piping includes a recycled material piping that is constituted of a recycled material of fluororesin.

In a preferred embodiment, the inner recycled material piping further has a barrier layer that is formed between the inner layer and the outer layer.

In a preferred embodiment, a thickness of the outer layer is less than a thickness of the inner layer.

In a preferred embodiment, coloring is performed on the inner recycled material piping.

In a preferred embodiment, the plurality of pipings include a recycled material piping that is constituted of a recycled material of fluororesin, coloring is performed on the recycled material piping, and marking is performed on at least one of either of the inner recycled material piping and the recycled material piping.

### Advantageous Effect of Invention

According to the substrate processing apparatus of the present invention, it is possible to save environmental resources.

### Brief Description of Drawings

[FIG. 1] is a schematic view of a substrate processing apparatus according to a preferred embodiment of the present invention.
[FIGS. 2A and 2B] are a view illustrating a section of an inner virgin material piping that is provided in the substrate processing apparatus according to the preferred embodiment of the present invention (FIG. 2A) and a view illustrating a section of an inner recycled material piping that is provided in the substrate processing apparatus according to the preferred embodiment of the present invention (FIG. 2B).
[FIGS. 3A and 3B] are a view illustrating a section of a virgin material piping that is provided in the substrate processing apparatus according to the preferred embodiment of the present invention (FIG. 3A) and a view illustrating a section of a recycled material piping that is provided in the substrate processing apparatus according to the preferred embodiment of the present invention (FIG. 3B).
[FIG. 4] is a sectional view schematically illustrating an arrangement of a substrate processing portion included in the substrate processing apparatus according to the preferred embodiment of the present invention.
[FIG. 5] is a view illustrating a portion of the arrangement of the substrate processing apparatus according to the preferred embodiment of the present invention.
[FIGS. 6A and 6B] are a view illustrating a modification example of the inner virgin material piping (FIG. 6A) and a view illustrating a modification example of the inner recycled material piping (FIG. 6B).
[FIGS. 7A to 7D] are a view illustrating a modification example of the inner virgin material piping (FIG. 7A), a view illustrating a modification example of the inner recycled material piping (FIG. 7B), a view illustrating the virgin material piping (FIG. 7C), and a view illustrating a modification example of the recycled material piping (FIG. 7D) .

### Description of Embodiments

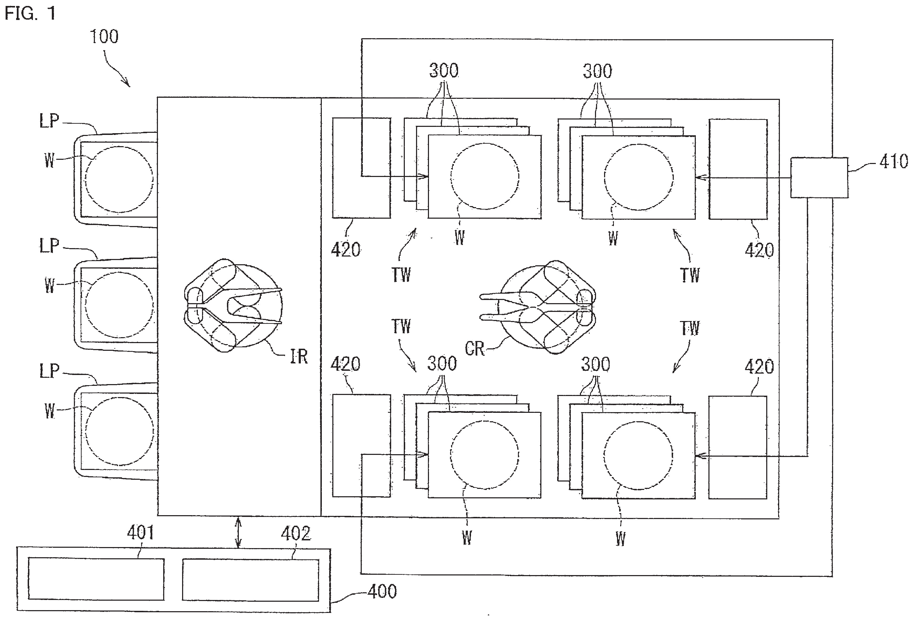

Hereinafter, a preferred embodiment according to a substrate processing apparatus of the present invention shall be described with reference to the drawings (FIG. 1 to FIG. 7D). However, the present invention is not restricted to the preferred embodiments described below and can be implemented in various modes within a scope not deviating from its gist. It is noted that, for portions for which description is redundant, the description is at times omitted as appropriate. Also, in the figures, same or corresponding portions are provided with the same reference sign and description shall not be repeated.

As a "substrate" that becomes a target of substrate processing in the substrate processing apparatus according to the present invention, any of various substrates such as semiconductor wafers, glass substrates for photomasks, glass substrates for liquid crystal displays, glass substrates for plasma displays, substrates for FEDs (field emission displays), substrates for optical disks, substrate for magnetic disks, substrates for magnetooptical disks, etc., is applicable. Although the preferred embodiments of the present invention shall mainly be described below with a case where a disk-shaped semiconductor wafer is a target of the substrate processing as an example, application to any of the various substrates other than the semiconductor wafer described above. Also, a shape of the substrate is not restricted to the disk shape, and the substrate processing apparatus according to the present invention is applicable to substrates having various shapes.

FIG. 1 is a schematic view of a substrate processing apparatus 100 according to the present preferred embodiment. In detail, FIG. 1 is a schematic plan view of the substrate processing apparatus 100 according to the present preferred embodiment. The substrate processing apparatus 100 processes substrates W. The substrate processing apparatus 100 according to the present preferred embodiment is a single substrate processing type apparatus and processes the substrates W one by one using a processing liquid. The substrate processing apparatus 100 is, for example, a cleaning apparatus or an etching apparatus.

As illustrated in FIG. 1, the substrate processing apparatus 100 includes a plurality of substrate processing portions 300, a fluid cabinet 410, a plurality of fluid boxes 420, a plurality of load ports LP, an indexer robot IR, a center robot CR, and a controller 400.

Each of the load ports LP houses a plurality of substrates W in a stacked state. The indexer robot IR transfers the substrate W between the load ports LP and the center robot CR. The center robot CR transfers the substrate W between the indexer robot IR and the substrate processing portions 300. It is noted that a mount (pass) on which the substrate W is temporarily placed may be provided between the indexer robot IR and the center robot CR, and the substrate W may be indirectly delivered between the indexer robot IR and the center robot CR via the mount.

The plurality of substrate processing portions 300 form a plurality of towers TW (four towers TW in FIG. 1). The plurality of towers TW are disposed such as to surround the center robot CR in plan view. Each tower TW includes a plurality of substrate processing portions 300 (three substrate processing portions 300 in FIG. 1) which are stacked vertically.

The fluid cabinet 410 houses a fluid. The fluid includes a processing liquid. Alternatively, the fluid may include the processing liquid and a gas or may include just a gas. In the present preferred embodiment, the fluid cabinet 410 houses the processing liquid and the gas. The gas includes, for example, an inert gas. The inert gas is, for example, nitrogen gas. The processing liquid is not restricted in particular as long as the processing liquid is a liquid that is brought into contact with the substrate W. The processing liquid may include, for example, a chemical liquid and a rinse liquid.

The chemical liquid includes, for example, dilute hydrofluoric acid (DHF), hydrofluoric acid (HF), hydrofluoric nitric acid (a mixture liquid of hydrofluoric acid and nitric acid (HNO₃), buffered hydrofluoric acid (BHF), ammonium fluoride, HFEG (a mixture liquid of hydrofluoric acid and ethylene glycol), phosphoric acid (H₃PO₄), sulfuric acid, acetic acid, nitric acid, hydrochloric acid, ammonia water, hydrogen peroxide water, an organic acid (for example, citric acid, oxalic acid), an organic alkali (for example, TMAH: tetramethylammonium hydroxide), a mixture liquid of sulfuric acid and hydrogen peroxide water (SPM), a mixture liquid of ammonia and hydrogen peroxide water (SC1), a mixture liquid of hydrochloric acid and hydrogen peroxide water (SC2), isopropyl alcohol (IPA), methanol, ethanol, hydrofluoroether (HFE), a surfactant, or a corrosion inhibitor.

The rinse liquid is, for example, pure water (DIW; deionized water). In other words, the rinse liquid can be so-called "ultrapure water." However, the rinse liquid is not restricted to the deionized water. The rinse liquid can be, for example, carbonated water, electrolyzed ion water, hydrogen water, ozone water, ammonia water, or a diluted aqueous hydrochloric acid solution (for example, an aqueous hydrochloric acid solution having a concentration of approximately 10 ppm to 100 ppm).

Each fluid box 420 corresponds to one of the plurality of towers TW. The processing liquid and the gas in the fluid cabinet 410 are supplied via one of the fluid boxes 420 to all of the substrate processing portions 300 included in the corresponding tower TW. That is, the fluid cabinet 410 houses a fluid to be supplied to the substrate processing portions 300.

Each substrate processing portion 300 executes substrate processing on the substrate W. In the present preferred embodiment, the substrate processing portion 300 processes the substrate W using the processing liquid. For example, each substrate processing portion 300 performs etching processing or cleaning processing on the substrate W.

The controller 400 controls operations of respective portions of the substrate processing apparatus 100. For example, the controller 400 controls the substrate processing portions 300, the load ports LP, the indexer robot IR, and the center robot CR. The controller 400 includes a controlling portion 401 and a storage portion 402.

The controlling portion 401 controls the operations of the respective portions of the substrate processing apparatus 100 based on various items of information stored in the storage portion 402. The controlling portion 401 has, for example, a processor. The controlling portion 401 may have a CPU (central processing unit) or an MPU (micro processing unit) as the processor. Alternatively, the controlling portion 401 may have a general-purpose processing unit or a dedicated processor.

The storage portion 402 stores various items of information for controlling operation of the substrate processing apparatus 100. For example, the storage portion 402 stores various items of data and various computer programs. The various items of data include recipe data. The recipe data indicates a recipe that prescribes processing details, processing conditions, and a processing procedure of the substrate W. In the recipe, various setting values are set as the processing conditions.

The storage portion 402 has a main storage device. The main storage device includes, for example, a semiconductor memory. The storage portion 402 may further have an auxiliary storage device. The auxiliary storage device includes, for example, at least one of a semiconductor memory and a hard disk drive. The storage portion 402 may include a removable medium.

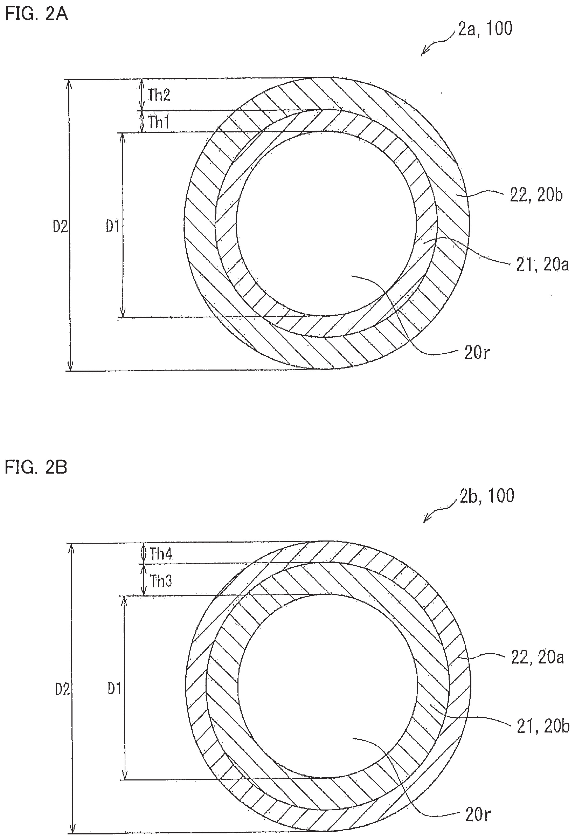

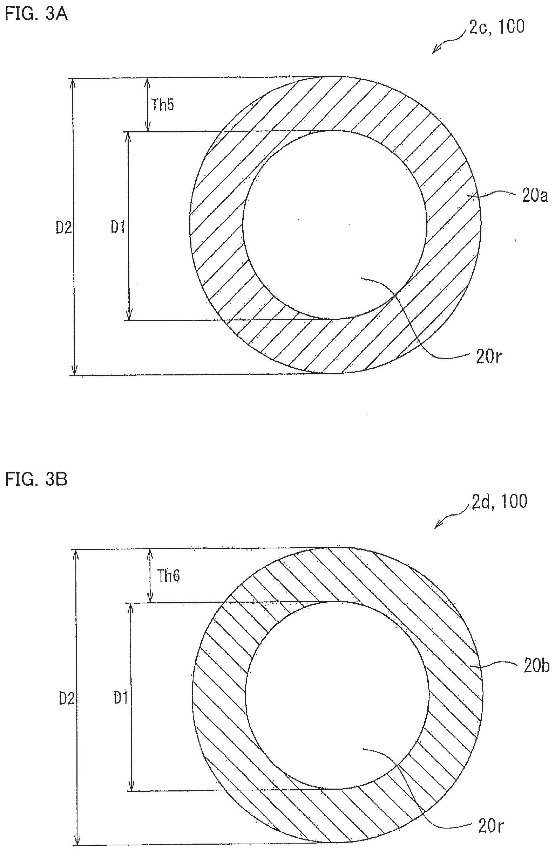

Next, with reference to FIG. 2A, FIG. 2B, FIG. 3A, and FIG. 3B, an inner virgin material piping 2a, an inner recycled material piping 2b, a virgin material piping 2c, and a recycled material piping 2d provided in the substrate processing apparatus 100 according to the present preferred embodiment shall be described. FIG. 2A is a view illustrating a section of the inner virgin material piping 2a that is provided in the substrate processing apparatus 100 of the present preferred embodiment. FIG. 2B is a view illustrating a section of the inner recycled material piping 2b provided in the substrate processing apparatus 100 of the present preferred embodiment. FIG. 3A is a view illustrating a section of the virgin material piping 2c provided in the substrate processing apparatus 100 of the present preferred embodiment. FIG. 3B is a view illustrating a section of the recycled material piping 2d provided in the substrate processing apparatus 100 of the present preferred embodiment.

As illustrated in FIG. 2A, the substrate processing apparatus 100 includes the inner virgin material piping **2a.** As illustrated in FIG. 2B, the substrate processing apparatus 100 includes the inner recycled material piping 2b. As illustrated in FIG. 3A, the substrate processing apparatus 100 includes the virgin material piping 2c. As illustrated in FIG. 3B, the substrate processing apparatus 100 includes the recycled material piping **2d.** The inner virgin material piping 2a, the inner recycled material piping 2b, the virgin material piping 2c, and the recycled material piping 2d are tubular members that make a fluid flow. Specifically, the inner virgin material piping 2a makes the processing liquid or the gas flow. Similarly, the inner recycled material piping 2b, the virgin material piping 2c, and the recycled material piping 2d make the processing make the processing liquid or the gas flow.

As illustrated in FIG. 2A, the inner virgin material piping 2a has an inner layer 21 and an outer layer 22. The outer layer 22 is formed on an outer side of the inner layer 21. In the present preferred embodiment, the inner virgin material piping 2a is a two-layer piping. The inner virgin material piping 2a is manufactured by an extrusion molding method, for example.

The inner layer 21 of the inner virgin material piping 2a contains a virgin material 20a of fluororesin. Specifically, the inner layer 21 of the inner virgin material piping 2a is constituted of the virgin material 20a of fluororesin. It is noted that the virgin material 20a of fluororesin indicates a new product of fluororesin.

The inner layer 21 forms a flow passage 20r. Specifically, an inner space of the inner layer 21 serves as the flow passage 20r. Therefore, in the inner virgin material piping 2a, the virgin material 20a of fluororesin is exposed to the flow passage 20r. The fluid (the processing liquid or the gas) flows along the flow passage 20r. That is, the fluid flows on an inner side of the inner layer 21.

The outer layer 22 of the inner virgin material piping 2a contains a recycled material 20b of fluororesin. Specifically, the outer layer 22 of the inner virgin material piping 2a is constituted of the recycled material 20b of fluororesin. Therefore, in the inner virgin material piping 2a, the recycled material 20b of fluororesin is exposed to an atmosphere around the inner virgin material piping 2a.

A thickness Th1 (a wall thickness) of the inner layer 21 of the inner virgin material piping 2a is less than a thickness Th2 (a wall thickness) of the outer layer 22 of the inner virgin material piping 2a. Therefore, for example, the amount of fluororesin used for the inner virgin material piping 2a can be reduced, as compared with the case where the thickness Th1 of the inner layer 21 is equal to the thickness Th2 of the outer layer 22. Thus, it is possible to save environmental resources by reducing the amount of the virgin material of fluororesin used in the substrate processing apparatus 100.

An inner diameter D1 of the inner virgin material piping 2a is 4 [mm], for example. An outer diameter D2 of the inner virgin material piping 2a is 6 [mm], for example. A wall thickness (Th1 + Th2) of the inner virgin material piping 2a is 1 [mm], for example. The thickness Th1 of the inner layer 21 of the inner virgin material piping 2a is 0.2 [mm], for example. The thickness Th2 of the outer layer 22 of the inner virgin material piping 2a is 0.8 [mm], for example.

As illustrated in FIG. 2B, as with the inner virgin material piping 2a, the inner recycled material piping 2b has an inner layer 21 and an outer layer 22. In the present preferred embodiment, the inner recycled material piping 2b is a two-layer piping.

The inner layer 21 of the inner recycled material piping 2b contains the recycled material 20b of fluororesin. Specifically, the inner layer 21 of the inner recycled material piping 2b is constituted of the recycled material 20b of fluororesin. As with the inner virgin material piping 2a, the inner layer 21 of the inner recycled material piping 2b forms a flow passage 20r. Therefore, in the inner recycled material piping 2b, the recycled material 20b of fluororesin is exposed to the flow passage 20r.

The outer layer 22 of the inner recycled material piping 2b contains the virgin material 20a of fluororesin. Specifically, the outer layer 22 of the inner recycled material piping 2b is constituted of the virgin material 20a of fluororesin. Therefore, in the inner recycled material piping 2b, the virgin material 20a of fluororesin is exposed to an atmosphere around the inner recycled material piping 2b.

A thickness Th3 (a wall thickness) of the inner layer 21 of the inner recycled material piping 2b is greater than a thickness Th4 (a wall thickness) of the outer layer 22 of the inner recycled material piping 2b. Therefore, for example, the amount of fluororesin used for the inner recycled material piping 2b can be reduced, as compared with the case where the thickness Th3 of the inner layer 21 is equal to the thickness Th4 of the outer layer 22. Thus, it is possible to save environmental resources by reducing the amount of the virgin material of fluororesin used in the substrate processing apparatus 100.

The inner diameter D1 of the inner recycled material piping 2b is 4 [mm], for example. The outer diameter D2 of the inner recycled material piping 2b is 6 [mm], for example. A wall thickness (Th3 + Th4) of the inner recycled material piping 2b is 1 [mm], for example. The thickness Th3 of the inner layer 21 of the inner recycled material piping 2b is 0.8 [mm], for example. The thickness Th4 of the outer layer 22 of the inner recycled material piping 2b is 0.2 [mm], for example.

As illustrated in FIG. 3A, in the present preferred embodiment, the virgin material piping 2c is a tubular member consisting of one layer of fluororesin. The virgin material piping 2c forms a flow passage 20r. Specifically, an inner space of the virgin material piping 2c serves as the flow passage 20r. Therefore, the fluid (the processing liquid or the gas) flows on an inner side (in the flow passage 20r) of the virgin material piping 2c.

The virgin material piping 2c contains the virgin material 20a of fluororesin. Specifically, the virgin material piping 2c is constituted of the virgin material 20a of fluororesin. Therefore, in the virgin material piping 2c, the virgin material 20a of fluororesin is exposed to the flow passage 20r. Also, the virgin material 20a of fluororesin is exposed to an atmosphere around the virgin material piping 2c.

The inner diameter D1 of the virgin material piping 2c is, for example, 4 [mm]. The outer diameter D2 of the virgin material piping 2c is, for example, 6 [mm]. A thickness Th5 of the virgin material piping 2c is, for example, 1 [mm].

As illustrated in FIG. 3B, in the present preferred embodiment, the recycled material piping 2d is a tubular member consisting of one layer of fluororesin. As with the virgin material piping 2c, the recycled material piping 2d forms a flow passage 20r. Therefore, the fluid (the processing liquid or the gas) flows on an inner side (in the flow passage 20r) of the recycled material piping 2d.

The recycled material piping 2d contains the recycled material 20b of fluororesin. Specifically, the recycled material piping 2d is constituted of the recycled material 20b of fluororesin. Therefore, in the recycled material piping 2d, the recycled material 20b of fluororesin is exposed to the flow passage 20r. Also, the recycled material 20b of fluororesin is exposed to an atmosphere around the recycled material piping 2d.

The inner diameter D1 of the recycled material piping 2d is, for example, 4 [mm]. The outer diameter D2 of the recycled material piping 2d is, for example, 6 [mm]. A thickness Th6 of the recycled material piping 2d is, for example, 1 [mm].

Fluororesin used for the inner virgin material piping 2a, the inner recycled material piping 2b, the virgin material piping 2c, and the recycled material piping 2d are, for example, polytetrafluoroethylene (PTFE), a tetrafluoroethylene-perfluoroalkoxyethylene copolymer (PFA), a tetrafluoroethylene-hexafluoropropylene copolymer (FEP), or a tetrafluoroethylene-ethylene copolymer (ETFE).

For example, a virgin material and a recycled material of PFA are used for the inner virgin material piping 2a and the inner recycled material piping 2b that make the processing liquid flow. The virgin material of PFA is used for the virgin material piping 2c that makes the processing liquid flow. The recycled material of PFA is used for the recycled material piping 2d that makes the processing liquid flow. A virgin material and a recycled material of PFA or PTFE are used for the inner virgin material piping 2a and the inner recycled material piping 2b that make a gas flow. The virgin material of PFA or PTFE is used for the virgin material piping 2c that makes a gas flow. The recycled material of PFA or PTFE is used for the recycled material piping 2d that makes a gas flow.

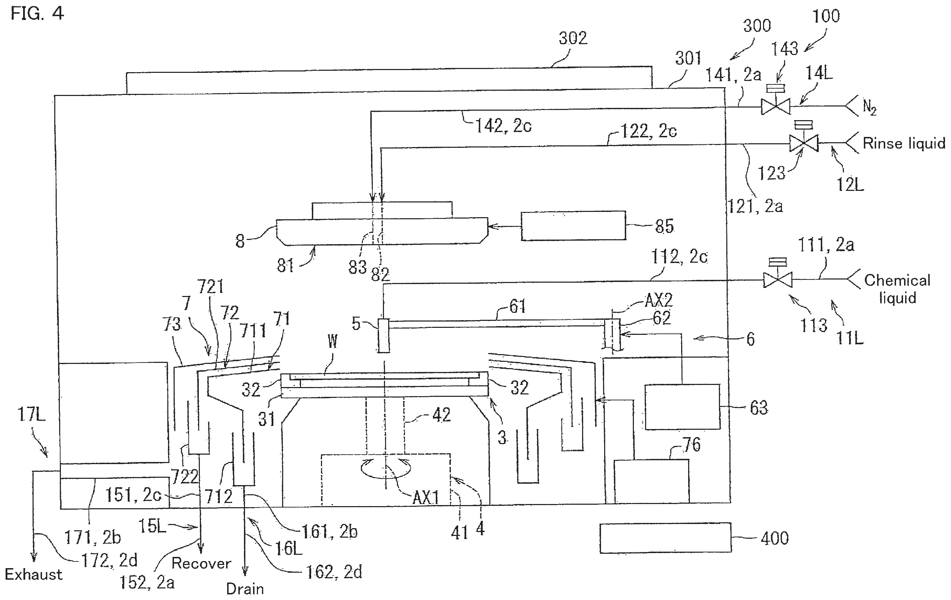

Next, the substrate processing apparatus 100 of the present preferred embodiment shall be described with reference to FIG. 4. FIG. 4 is a sectional view schematically illustrating an arrangement of the substrate processing portion 300 included in the substrate processing apparatus 100 of the present preferred embodiment.

As illustrated in FIG. 4, the substrate processing portion 300 has a chamber 301, an FFU (fan filter unit) 302, a spin chuck 3, a spin motor portion 4, a first nozzle 5, a nozzle moving portion 6, a liquid receiving portion 7, a blocking member 8, a first elevating/lowering portion 76, and a second elevating/lowering portion 85. The substrate processing apparatus 100 further includes a first processing liquid line 11L, a second processing liquid line 12L, a first gas line 14L, a recovery line 15L, a drain line 16L, and an exhaust line 17L.

The chamber 301 has a substantially box shape. The chamber 301 houses the spin chuck 3, the spin motor portion 4, the first nozzle 5, the nozzle moving portion 6, the liquid receiving portion 7, the blocking member 8, the first elevating/lowering portion 76, the second elevating/lowering portion 85, a portion of the first processing liquid line 11L, a portion of the second processing liquid line 12L, a portion of the first gas line 14L, a portion of the recovery line 15L, a portion of the drain line 16L, and a portion of the exhaust line 17L.

The substrate W is carried into the chamber 301. Therefore, the chamber 301 houses the substrate W. The substrate W is processed in the chamber 301.

The FFU 302 is disposed outside the chamber 301. The FFU 302 blows air toward an inner space of the chamber 301 and generate a downflow in the chamber 301.

More specifically, the FFU 302 blows, toward the inner space of the chamber 301, air in a clean room in which the substrate processing apparatus 100 is installed. In detail, the FFU 302 has blades, an electric motor, and a filter. The blades suck the air in the cleanroom by rotating and blow the sucked air toward the inner space of the chamber 301. The electric motor rotates the blades. The filter filters the air sent by the rotating blades. As a result, the air cleaned by the filter is blown toward the inner space of the chamber 301.

The spin chuck 3 holds the substrate W in a horizontal orientation. As illustrated in FIG. 4, the spin chuck 3 may have a spin base 31 and a plurality of chuck members 32. The spin base 31 has a substantially disk shape and supports the plurality of chuck members 32 in a horizontal orientation. The plurality of chuck members 32 are disposed on a peripheral edge portion of the spin base 31. The plurality of chuck members 32 clamps a peripheral edge portion of the substrate W. The substrate W is held in a horizontal orientation by the plurality of chuck members 32. Operation of the plurality of chuck members 32 is controlled by the controller 400 (the controlling portion 401).

The spin motor portion 4 integrally rotates the spin chuck 3 and the substrate W centered at a first rotational axis AX1 extending in a vertical direction. The controller 400 (the controlling portion 401) controls the rotation of the substrate W by the spin motor portion 4. In detail, the first rotational axis AX1 passes through a center of the spin base 31. The plurality of chuck members 32 are disposed such that a center of the substrate W faces the center of the spin base 31. Therefore, the substrate W rotates around the center of the substrate W as the rotation center.

As illustrated in FIG. 4, the spin motor portion 4 may have a motor main body 41 and a shaft 42. The shaft 42 is coupled to the spin base 31. The motor main body 41 rotates the shaft 42. As a result, the spin base 31 rotates. Operation of the motor main body 41 is controlled by the controller 400 (the controlling portion 401).

The first nozzle 5 is disposed inside the chamber 301 and discharges a chemical liquid (fluid) in the chamber 301. Specifically, the first nozzle 5 discharges a chemical liquid from a position above the substrate W held by the spin chuck 3 toward an upper surface of the rotating substrate W. The chemical liquid is discharged onto the upper surface of the rotating substrate W, and a liquid film of the chemical liquid is thereby formed on the upper surface of the substrate W. As a result, the upper surface of the substrate W is processed with the chemical liquid.

The first processing liquid line 11L supplies the chemical liquid to the first nozzle 5. As illustrated in FIG. 4, the first processing liquid line 11L has a first chemical liquid piping 111, a second chemical liquid piping 112, and a first opening-closing valve 113. The first chemical liquid piping 111 and the second chemical liquid piping 112 are tubular members through which the chemical liquid (liquid) flows.

The first chemical liquid piping 111 is disposed outside the chamber 301. The first chemical liquid piping 111 makes the chemical liquid (fluid) to be supplied to the substrate processing portion 300 flow. Specifically, the first chemical liquid piping 111 supplies the chemical liquid (liquid) to the substrate processing portion 300. A portion of the first chemical liquid piping 111 is housed in the fluid box 420 described with reference to FIG. 1. In the present preferred embodiment, the inner virgin material piping 2a described with reference to FIG. 2A is used for the first chemical liquid piping 111. The first chemical liquid piping 111 is an example of an "extra-chamber piping."

The second chemical liquid piping 112 is housed in the chamber 301. In other words, the second chemical liquid piping 112 is disposed inside the chamber 301. In the present preferred embodiment, the virgin material piping 2c described with reference to FIG. 3A is used for the second chemical liquid piping 112. The second chemical liquid piping 112 is an example of an "intra-chamber supply piping."

The second chemical liquid piping 112 makes the chemical liquid (fluid) to be supplied to the first nozzle 5 flow. Specifically, an upstream end of the second chemical liquid piping 112 is connected to a downstream end of the first chemical liquid piping 111. Therefore, the chemical liquid flows from the first chemical liquid piping 111 into the second chemical liquid piping 112. The second chemical liquid piping 112 makes the chemical liquid flowing thereinto from the first chemical liquid piping 111 flow to the first nozzle 5. For example, the upstream end of the second chemical liquid piping 112 and the downstream end of the first chemical liquid piping 111 may be connected via a joint.

The first opening-closing valve 113 is interposed in the first chemical liquid piping 111. The first opening-closing valve 113 is housed in the fluid box 420 described with reference to FIG. 1. The first opening-closing valve 113 can switch between an open state and a closed state. The controller 400 (the controlling portion 401) controls opening/closing operation of the first opening-closing valve 113. An actuator of the first opening-closing valve 113 is, for example, a pneumatic actuator.

The first opening-closing valve 113 controls flow and stop of the flow of the chemical liquid (liquid) via the first chemical liquid piping 111 and the second chemical liquid piping 112. In other words, the first opening-closing valve 113 controls supply and stop of the supply of the chemical liquid to the first nozzle 5.

The controller 400 (the controlling portion 401) puts the first opening-closing valve 113 in the open state when supplying the chemical liquid to the substrate W. As a result, the chemical liquid flows through the first chemical liquid piping 111 and the second chemical liquid piping 112 toward the first nozzle 5, and the chemical liquid is discharged from the first nozzle 5 toward the substrate W.

The controller 400 (the controlling portion 401) puts the first opening-closing valve 113 in the closed state when stopping discharge of the chemical liquid from the first nozzle 5. As a result, the flow of the chemical liquid via the first chemical liquid piping 111 and the second chemical liquid piping 112 is stopped, and the discharge of the chemical liquid from the first nozzle 5 is stopped.

According to the present preferred embodiment, the inner virgin material piping 2a is used for the first chemical liquid piping 111, and the virgin material piping 2c is used for the second chemical liquid piping 112. Since inner surfaces of the inner virgin material piping 2a and the virgin material piping 2c are cleaner as compared with inner surfaces of the inner recycled material piping 2b and the recycled material piping 2d, it becomes less likely that the number of particles on the substrate W increases, as compared with the case where the inner recycled material piping 2b or the recycled material piping 2d is used for the first chemical liquid piping 111 and the second chemical liquid piping 112.

Also, an outer surface of the virgin material piping 2c is cleaner as compared with an outer surface of the inner virgin material piping 2a. Therefore, by using the virgin material piping 2c for the second chemical liquid piping 112, it becomes less likely that an interior of the chamber 301 is contaminated as compared with a case where the inner virgin material piping 2a is used for the second chemical liquid piping 112. As a result, it becomes less likely that the number of particles on the substrate W increases, as compared with the case where the inner virgin material piping 2a is used for the second chemical liquid piping 112.

Also, according to the present preferred embodiment, by using the inner virgin material piping 2a for the first chemical liquid piping 111, it is possible to save environmental resources by reducing the amount of the virgin material of fluororesin used in the substrate processing apparatus 100 as compared with a case where the virgin material piping 2c is used for the first chemical liquid piping 111.

The nozzle moving portion 6 moves the first nozzle 5 along a horizontal plane. The nozzle moving portion 6 is controlled by the controller 400 (the controlling portion 401). In more detail, the nozzle moving portion 6 moves the first nozzle 5 between a first retracted position and a processing position. The first retracted position is a position on an outer side of the spin chuck 3. For example, the first retracted position may be a position on an outer side of the liquid receiving portion 7. In the present preferred embodiment, the processing position is a position facing the center of the substrate W. The first nozzle 5 discharges the chemical liquid from the processing position toward the substrate W.

As illustrated in FIG. 4, the nozzle moving portion 6 may have a nozzle arm 61, a nozzle base 62, and a nozzle moving mechanism 63. The nozzle base 62 extends in the vertical direction. A proximal end portion of the nozzle arm 61 is coupled to the nozzle base 62. The nozzle arm 61 extends horizontally from the nozzle base 62. The nozzle arm 61 supports the first nozzle 5. The first nozzle 5 projects vertically downward from the nozzle arm 61.

The nozzle moving mechanism 63 rotates the nozzle base 62 in both forward and reverse directions centered at a second rotational axis AX2 extending in the vertical direction. As a result, the first nozzle 5 moves along a circumferential direction centered at the second rotational axis AX2. The nozzle moving mechanism 63 is controlled by the controller 400 (the controlling portion 401). An actuator of the nozzle moving mechanism 63 may have, for example, an electric motor rotatable in both the forward and reverse directions and a speed reducer.

The blocking member 8 is positioned above the substrate W held by the spin chuck 3. A lower surface 81 of the blocking member 8 faces the upper surface of the substrate W held by the spin chuck 3. The lower surface 81 has, for example, a circular shape. The size of a diameter of the lower surface 81 is equal to or larger than a diameter of the substrate W and is smaller than an inner diameter of the liquid receiving portion 7. In FIG. 4, hatching of the blocking member 8 is omitted.

The second elevating/lowering portion 85 elevates and lowers the blocking member 8 between a second retracted position and a blocking position. The blocking position is a position lower than the second retracted position. Specifically, the blocking position is a position closer to the substrate W held by the spin chuck 3 as compared with the second retracted position. FIG. 4 illustrates the blocking member 8 positioned at the second retracted position.

When the blocking member 8 is moved from the second retracted position to the blocking position, a processing space is formed by the liquid receiving portion 7 and the blocking member 8. The processing space is a space substantially blocked from an atmosphere outside the processing space. That is, the processing space is a local space formed inside the chamber 301. The processing space is substantially blocked from an atmosphere inside the chamber 301.

The second elevating/lowering portion 85 is controlled by the controller 400 (the controlling portion 401). An actuator of the second elevating/lowering portion 85 includes, for example, an electric motor rotatable in both forward and reverse directions and a ball screw mechanism.

As illustrated in FIG. 4, the blocking member 8 has a second nozzle 82 and a third nozzle 83. Therefore, the second nozzle 82 and the third nozzle 83 are disposed inside the chamber 301. Discharge ports of the second nozzle 82 and the third nozzle 83 are open in the lower surface 81 of the blocking member 8. The discharge ports of the second nozzle 82 and the third nozzle 83 may be disposed at positions facing a central portion of the substrate W held by the spin chuck 3.

The second nozzle 82 discharges the rinse liquid (fluid) in the chamber 301. Specifically, the second nozzle 82 discharges the rinse liquid toward the upper surface of the substrate W. The third nozzle 83 discharges an inert gas (fluid) in the chamber. In the present preferred embodiment, through the third nozzle 83 discharges nitrogen gas.

As illustrated in FIG. 4, the second processing liquid line 12L supplies the rinse liquid to the second nozzle 82. Specifically, the second processing liquid line 12L has a first rinse liquid piping 121, a second rinse liquid piping 122, and a second opening-closing valve 123.

The first rinse liquid piping 121 is disposed outside the chamber 301. The first rinse liquid piping 121 makes the rinse liquid (fluid) to be supplied to the substrate processing portion 300 flow. Specifically, the first rinse liquid piping 121 supplies the rinse liquid (liquid) to the substrate processing portion 300.

The second rinse liquid piping 122 makes the rinse liquid (fluid) to be supplied to the second nozzle 82 flow. Specifically, an upstream end of the second rinse liquid piping 122 is connected to a downstream end of the first rinse liquid piping 121. The second rinse liquid piping 122 makes the rinse liquid flowing in from the first rinse liquid piping 121 flow to the second nozzle 82.

In the present preferred embodiment, the inner virgin material piping 2a described with reference to FIG. 2A is used for the first rinse liquid piping 121, and the virgin material piping 2c described with reference to FIG. 3A is used for the second rinse liquid piping 122. The first rinse liquid piping 121 is an example of the "extra-chamber piping," and the second rinse liquid piping 122 is an example of the "intra-chamber supply piping." Since an arrangement of the second processing liquid line 12L is substantially the same as the first processing liquid line 11L, the detailed description thereof shall be omitted.

According to the present preferred embodiment, the inner virgin material piping 2a is used for the first rinse liquid piping 121, and the virgin material piping 2c is used for the second rinse liquid piping 122. Therefore, as with the first processing liquid line 11L, it becomes less likely that the number of particles on the substrate W increases, and it becomes less likely that the interior of the chamber 301 is contaminated. Also, as with the first processing liquid line 11L, it is possible to save environmental resources by reducing the amount of the virgin material of fluororesin used in the substrate processing apparatus 100.

As illustrated in FIG. 4, the first gas line 14L supplies an inert gas to the third nozzle 83. In the present preferred embodiment, the first gas line 14L supplies nitrogen gas to the third nozzle 83. Specifically, the first gas line 14L has a first gas piping 141, a second gas piping 142, and a third opening-closing valve 143.

The first gas piping 141 is disposed outside the chamber 301. The first gas piping 141 makes the inert gas (fluid) to be supplied to the substrate processing portion 300 flow. Specifically, the first gas piping 141 supplies nitrogen gas (gas) to the substrate processing portion 300.

The second gas piping 142 makes the inert gas (fluid) to be supplied to the third nozzle 83 flow. Specifically, an upstream end of the second gas piping 142 is connected to a downstream end of the first gas piping 141. The second gas piping 142 makes the inert gas flowing in from the first gas piping 141 flow to the third nozzle 83.

In the present preferred embodiment, the inner virgin material piping 2a described with reference to FIG. 2A is used for the first gas piping 141, and the virgin material piping 2c described with reference to FIG. 3A is used for the second gas piping 142. The first gas piping 141 is an example of the "extra-chamber piping," and the second gas piping 142 is an example of the "intra-chamber supply piping." Since an arrangement of the first gas line 14L is substantially the same as the first processing liquid line 11L, the detailed description thereof shall be omitted.

According to the present preferred embodiment, the inner virgin material piping 2a is used for the first gas piping 141, and the virgin material piping 2c is used for the second gas piping 142. Therefore, it becomes less likely that the interior of the chamber 301 is contaminated as compared with a case where the inner recycled material piping 2b or the recycled material piping 2d is used for the first gas piping 141 and the second gas piping 142. As a result, it becomes less likely that the number of particles on the substrate W increases, as compared with the case where the inner recycled material piping 2b or the recycled material piping 2d is used for the first gas piping 141 and the second gas piping 142. Also, by using the inner virgin material piping 2a for the first gas piping 141, it is possible to save environmental resources by reducing the amount of the virgin material of fluororesin used in the substrate processing apparatus 100 as compared with a case where the virgin material piping 2c is used for the first gas piping 141.

The liquid receiving portion 7 receives the chemical liquid expelled from the substrate W. The liquid receiving portion 7 further receives the rinse liquid expelled from the substrate W. In detail, the liquid receiving portion 7 includes a first liquid receiving portion 71 and a second liquid receiving portion 72. The first liquid receiving portion 71 is disposed on an inner side of the second liquid receiving portion 72. The first liquid receiving portion 71 receives the rinse liquid expelled from the substrate W. The second liquid receiving portion 72 receives the chemical liquid expelled from the substrate W.

As illustrated in FIG. 4, the first liquid receiving portion 71 has a first guard portion 711 and a first cup portion 712. The second liquid receiving portion 72 has a second guard portion 721 and a second cup portion 722.

The first guard portion 711 has a substantially cylindrical shape surrounding the spin chuck 3 and the spin motor portion 4 and is disposed around the spin chuck 3 and the spin motor portion 4. The first guard portion 711 receives the rinse liquid that scatters from the rotating substrate W.

The first cup portion 712 forms an annular groove below a lower end of the first guard portion 711. The rinse liquid flowing down from an inner peripheral surface of the first guard portion 711 is collected in the first cup portion 712.

The second guard portion 721 has a substantially cylindrical shape surrounding the first guard portion 711 and is disposed around the first guard portion 711. The second guard portion 721 receives the chemical liquid that scatters from the rotating substrate W.

The second cup portion 722 forms an annular groove below a lower end of the second guard portion 721. The chemical liquid flowing down from an inner peripheral surface of the second guard portion 721 is collected in the second cup portion 722.

It is noted that, as illustrated in FIG. 4, the liquid receiving portion 7 further has a third liquid receiving portion 73. The third liquid receiving portion 73 is a guard portion. The detailed description of the third liquid receiving portion 73 shall be omitted.

The first elevating/lowering portion 76 individually elevates and lowers the first guard portion 711, the second guard portion 721, and the third liquid receiving portion 73 (guard portion). The first elevating/lowering portion 76 is controlled by the controller 400 (the controlling portion 401). Specifically, the first elevating/lowering portion 76 individually elevates and lowers the first guard portion 711, the second guard portion 721, and the third liquid receiving portion 73 (guard portion) between a liquid receiving position and a third retracted position. The liquid receiving position is a position higher than the third retracted position. The first elevating/lowering portion 76 includes, for example, an electric motor rotatable in both forward and reverse directions and a ball screw mechanism. FIG. 4 illustrates the first guard portion 711, the second guard portion 721, and the third liquid receiving portion 73 (guard portion) positioned at the liquid receiving position.

The drain line 16L expels the rinse liquid collected in the first cup portion 712 to the outside of the substrate processing portion 300 (the chamber 301). For example, the drain line 16L guides the rinse liquid collected in the first cup portion 712 to a piping that is connected to waste liquid equipment of a plant where the substrate processing apparatus 100 is installed. That is, the drain line 16L expels the rinse liquid collected in the first cup portion 712 to the outside of the substrate processing apparatus 100. Alternatively, the drain line 16L may expel the rinse liquid collected in the first cup portion 712 to a drain tank disposed outside the substrate processing portion 300 or may expel to the outside of the substrate processing apparatus 100 via the drain tank.

As illustrated in FIG. 4, the drain line 16L has a first drain piping 161 and a second drain piping 162. The first drain piping 161 and the second drain piping 162 are tubular members through which the processing liquid (liquid) flows. Through the first drain piping 161 and the second drain piping 162, the chemical liquid (fluid) is expelled from the substrate processing portion 300 (the chamber 301). The first drain piping 161 and the second drain piping 162 are an example of an "drain piping."

The first drain piping 161 is housed in the chamber 301. In other words, the first drain piping 161 is disposed inside the chamber 301. One end of the first drain piping 161 is connected to a bottom portion of the first cup portion 712. As a result, the rinse liquid collected in the first cup portion 712 flows into the first drain piping 161. In the present preferred embodiment, the inner recycled material piping 2b described with reference to FIG. 2B is used for the first drain piping 161. The first drain piping 161 is an example of an "intra-chamber drain piping."

The second drain piping 162 is disposed outside the chamber 301. An upstream end of the second drain piping 162 is connected to a downstream end of the first drain piping 161. Therefore, the rinse liquid flows from the first drain piping 161 into the second drain piping 162. As a result, the rinse liquid (liquid) expelled from the substrate processing portion 300 (the chamber 301) flows through the second drain piping 162. For example, the downstream end of the first drain piping 161 and the upstream end of the second drain piping 162 may be connected via a joint. In the present preferred embodiment, the recycled material piping 2d described with reference to FIG. 3B is used for the second drain piping 162. The second drain piping 162 is an example of an "extra-chamber drain piping."

The second drain piping 162 makes the rinse liquid flowed into the second drain piping 162 via the first drain piping 161 flow to the piping that is connected to the waste liquid equipment of the plant where the substrate processing apparatus 100 is installed. That is, the second drain piping 162 makes the rinse liquid collected in the first cup portion 712 flow to the outside of the substrate processing apparatus 100. Alternatively, the second drain piping 162 may make the rinse liquid flowed into the second drain piping 162 via the first drain piping 161 flow to a drain tank that is disposed outside the substrate processing portion 300 or flow to the outside of the substrate processing apparatus 100 via the drain tank.

An outer surface of the inner recycled material piping 2b is cleaner as compared with outer surfaces of the inner virgin material piping 2a and the recycled material piping 2d. Therefore, by using the inner recycled material piping 2b for the first drain piping 161, it becomes less likely that the interior of the chamber 301 is contaminated as compared with a case where the inner virgin material piping 2a or the recycled material piping 2d is used for the first drain piping 161. As a result, it becomes less likely that the number of particles on the substrate W increases, as compared with the case where the inner virgin material piping 2a or the recycled material piping 2d is used for the first drain piping 161.

Also, according to the present preferred embodiment, by using the inner recycled material piping 2b for the first drain piping 161 and using the recycled material piping 2d for the second drain piping 162, it is possible to save environmental resources by reducing the amount of the virgin material of fluororesin used in the substrate processing apparatus 100 as compared with a case where the virgin material piping 2c is used for the first drain piping 161 and the second drain piping 162.

The recovery line 15L guides the chemical liquid collected in the second cup portion 722 to the outside of the substrate processing portion 300 (the chamber 301). More specifically, the recovery line 15L guides the chemical liquid collected in the second cup portion 722 to the fluid cabinet 410 described with reference to FIG. 1. As a result, the chemical liquid collected in the second cup portion 722 is collected in the fluid cabinet 410.

As illustrated in FIG. 4, the recovery line 15L has a first recovery piping 151 and a second recovery piping 152. The first recovery piping 151 and the second recovery piping 152 are tubular members through which the processing liquid (liquid) flows. The first recovery piping 151 and the second recovery piping 152 make the chemical liquid (liquid) discharged from the substrate processing portion 300 (the chamber 301) recovered in the fluid cabinet 410 described with reference to FIG. 1. The first recovery piping 151 and the second recovery piping 152 are an example of a "recovery piping."

Specifically, the first recovery piping 151 is housed inside the chamber 301. In other words, the first recovery piping 151 is disposed inside the chamber 301. One end of the recovery piping 151 is connected to a bottom portion of the second cup portion 722. Therefore, the chemical liquid collected in the second cup portion 722 flows into the first recovery piping 151. In the present preferred embodiment, the virgin material piping 2c described with reference to FIG. 3A is used for the first recovery piping 151. The first recovery piping 151 is an example of an "intra-chamber recovery piping."

The second recovery piping 152 is disposed outside the chamber 301. An upstream end of the second recovery piping 152 is connected to a downstream end of the first recovery piping 151. Therefore, the chemical liquid flows from the first recovery piping 151 into the second recovery piping 152. As a result, the chemical liquid (liquid) discharged from the substrate processing portion 300 (the chamber 301) flows through the second recovery piping 152. For example, the downstream end of the first recovery piping 151 and the upstream end of the second recovery piping 152 may be connected via a joint.

The second recovery piping 152 makes the chemical liquid flowing into the second recovery piping 152 via the first recovery piping 151 flow to the fluid cabinet 410 described with reference to FIG. 1. In the present preferred embodiment, the inner virgin material piping 2a described with reference to FIG. 2A is used for the second recovery piping 152. The second recovery piping 152 is an example of an "extra-chamber recovery piping."

According to the present preferred embodiment, the virgin material piping 2c is used for the first recovery piping 151, and the inner virgin material piping 2a is used for the second recovery piping 152. The chemical liquid which flows through the first recovery piping 151 and the second recovery piping 152 is recovered in the fluid cabinet 410 and used again for the substrate processing. Therefore, it becomes less likely that the number of particles on the substrate W increases, as compared with the case where the inner recycled material piping 2b or the recycled material piping 2d is used for the first recovery piping 151 and the second recovery piping 152.

Also, the outer surface of the virgin material piping 2c is cleaner as compared with the outer surfaces of the inner virgin material piping 2a and the recycled material piping 2d. Therefore, by using the virgin material piping 2c for the first recovery piping 151, it becomes less likely that the interior of the chamber 301 is contaminated as compared with a case where the inner virgin material piping 2a or the recycled material piping 2d is used for the first recovery piping 151. As a result, it becomes less likely that the number of particles on the substrate W increases, as compared with the case where the inner virgin material piping 2a or the recycled material piping 2d is used for the first recovery piping 151.

Also, according to the present preferred embodiment, by using the inner virgin material piping 2a for the second recovery piping 152, it is possible to save environmental resources by reducing the amount of the virgin material of fluororesin used in the substrate processing apparatus 100 as compared with a case where the virgin material piping 2c is used for the second recovery piping 152.

The exhaust line 17L expels the gas in the chamber 301 to the outside of the chamber 301. Specifically, the exhaust line 17L has a first exhaust piping 171 and a second exhaust piping 172. The first exhaust piping 171 and the second exhaust piping 172 are tubular members through which a gas flows. The first exhaust piping 171 and the second exhaust piping 172 makes a gas (fluid) flow out from the substrate processing portion 300 (the chamber 301). The first exhaust piping 171 and the second exhaust piping 172 are an example of the "drain piping."

The first exhaust piping 171 is housed in the chamber 301. In other words, the first exhaust piping 171 is disposed inside the chamber 301. One end of the first exhaust piping 171 communicates with the inner space of the chamber 301 at a position lower than the spin chuck 3. In the present preferred embodiment, the inner recycled material piping 2b described with reference to FIG. 2B is used for the first exhaust piping 171. The first exhaust piping 171 is an example of the "intra-chamber drain piping."

The second exhaust piping 172 is disposed outside the chamber 301. An upstream end of the second exhaust piping 172 is connected to a downstream end of the first exhaust piping 171. For example, the downstream end of the first exhaust piping 171 and the upstream end of the second exhaust piping 172 may be connected via a joint. In the present preferred embodiment, the recycled material piping 2d described with reference to FIG. 3B is used for the second exhaust piping 172. The second exhaust piping 172 is an example of the "extra-chamber drain piping."

Gases in the first exhaust piping 171 and the second exhaust piping 172 are constantly sucked by exhaust equipment (not illustrated) provided in the plant in which the substrate processing apparatus 100 is installed. Therefore, when the substrate W is processed with the chemical liquid, a chemical liquid atmosphere in the chamber 301 is sucked to an upstream end of the first exhaust piping 171 by a suction force of the exhaust equipment which is transmitted through the exhaust line 17L. As a result, the chemical liquid atmosphere in the chamber 301 is expelled to the outside of the substrate processing portion 300 (the chamber 301) through the exhaust line 17L. Similarly, when the processing space is formed by the blocking member 8 and the liquid receiving portion 7, the inert gas (nitrogen gas) introduced into the processing space is expelled to the outside of the substrate processing portion 300 (the chamber 301) through the exhaust line 17L.

According to the present preferred embodiment, by using the inner recycled material piping 2b for the first exhaust piping 171, it becomes less likely that the interior of the chamber 301 is contaminated, as with the drain line 16L. As a result, it becomes less likely that the number on particles of the substrate W increases, as with the drain line 16L.

Also, according to the present preferred embodiment, by using the inner recycled material piping 2b for the first exhaust piping 171 and using the recycled material piping 2d for the second exhaust piping 172, it is possible to save environmental resources by reducing the amount of the virgin material of fluororesin used in the substrate processing apparatus 100, as with the drain line 16L.

Next, with reference to FIG. 4, substrate processing performed by the substrate processing apparatus 100 of the present preferred embodiment shall be described. First, the controller 400 (the controlling portion 401) controls the center robot CR described with reference to FIG. 1 to carry the to-be-processed substrate W into the chamber 301. Then, the controller 400 (the controlling portion 401) controls the spin chuck 3 such that the spin chuck 3 holds the substrate W carried in by the center robot CR.

When the substrate W is held by the spin chuck 3, the controller 400 (the controlling portion 401) controls the spin motor portion 4 to integrally rotate the spin chuck 3 and the substrate W. Also, the controller 400 (the controlling portion 401) controls the first elevating/lowering portion 76 to move the second guard portion 721 and the third liquid receiving portion 73 (guard portion) from the third retracted position to the liquid receiving position with the first guard portion 711 being positioned as it is at the third retracted position. Then, the controller 400 (the controlling portion 401) controls the nozzle moving portion 6 to move the first nozzle 5 from the first retracted position to the processing position.

After moving the first nozzle 5 to the processing position, the controller 400 (the controlling portion 401) opens the first opening-closing valve 113. When the first opening-closing valve 113 is opened, the chemical liquid is supplied to the first nozzle 5 via the first chemical liquid piping 111 and the second chemical liquid piping 112, and the chemical liquid is discharged from the first nozzle 5 toward the central portion of the rotating substrate W. As a result, the liquid film of the chemical liquid is formed on the upper surface of the substrate W, and the substrate W is processed with the chemical liquid.

The chemical liquid supplied to the rotating substrate W is expelled to the periphery of the substrate W. The chemical liquid expelled from the substrate W is received by the second guard portion 721. The chemical liquid received by the second guard portion 721 flows into the first recovery piping 151 via the second cup portion 722. As a result, the chemical liquid expelled from the substrate W is recovered via the recovery line 15L into the fluid cabinet 410 described with reference to FIG. 1.

The controller 400 (the controlling portion 401) closes the first opening-closing valve 113 when a predetermined time elapses from when the discharge of the chemical liquid is started. When the first opening-closing valve 113 is put in the closed state, the flow of the chemical liquid via the first chemical liquid piping 111 and the second chemical liquid piping 112 is stopped, and the discharge of the chemical liquid from the first nozzle 5 is stopped. As a result, processing of the substrate W with the chemical liquid is ended.

After the processing of the substrate W with the chemical liquid is ended, the controller 400 (the controlling portion 401) controls the nozzle moving portion 6 to move the first nozzle 5 from the processing position to the first retracted position.

Upon moving the first nozzle 5 from the processing position to the first retracted position, the controller 400 (the controlling portion 401) controls the second elevating/lowering portion 85 to move the blocking member 8 from the second retracted position to the blocking position and forms the processing space. Also, the controller 400 (the controlling portion 401) controls the first elevating/lowering portion 76 to move the first guard portion 711 from the third retracted position to the liquid receiving position.

After forming the processing space, the controller 400 (the controlling portion 401) opens the third opening-closing valve 143. As a result, the nitrogen gas is supplied from the third nozzle 83 to the processing space, and an atmosphere in the processing space is replaced from an air atmosphere to a nitrogen atmosphere.

After the supply of nitrogen gas is started, the controller 400 (the controlling portion 401) opens the second opening-closing valve 123. When the second opening-closing valve 123 is opened, the rinse liquid is supplied to the second nozzle 82 via the first rinse liquid piping 121 and the second rinse liquid piping 122, and the rinse liquid is discharged from the second nozzle 82 toward the central portion of the rotating substrate W. As a result, the chemical liquid remaining on the substrate W is washed away by the rinse liquid, and a liquid film of the rinse liquid is formed on the upper surface of the substrate W.

The controller 400 (the controlling portion 401) closes the second opening-closing valve 123 when a predetermined time elapses from when the discharge of the rinse liquid is started. When the second opening-closing valve 123 is put in the closed state, the flow of the rinse liquid via the first rinse liquid piping 121 and the second rinse liquid piping 122 is stopped, and the discharge of the rinse liquid from the second nozzle 82 is stopped. As a result, rinse processing is ended.

After the discharge of the rinse liquid is stopped, the controller 400 (the controlling portion 401) controls the spin motor portion 4 to increase a rotation speed of the substrate W and rotate the substrate W at a high speed. By rotating the substrate W at a high speed, the rinse liquid adhering to the substrate W scatters from the substrate W, and the substrate W is dried. When a predetermined time elapses from when the rotation speed of the substrate W is increased, the controller 400 (the controlling portion 401) controls the spin motor portion 4 to stop the rotation of the substrate W. As a result, drying processing is ended.

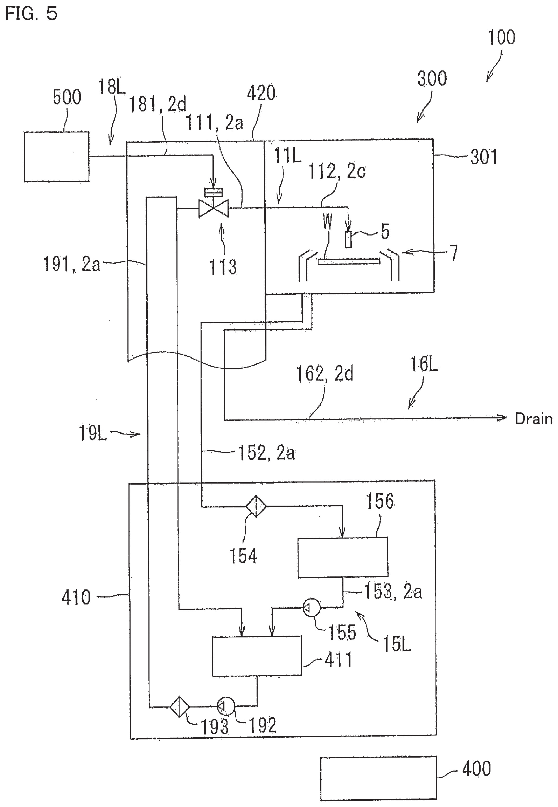

Next, with reference to FIG. 5, the substrate processing apparatus 100 of the present preferred embodiment shall be described. FIG. 5 is a view illustrating a portion of the arrangement of the substrate processing apparatus 100 of the present preferred embodiment. As illustrated in FIG. 5, the substrate processing apparatus 100 further includes a storage tank 411, a recovery tank 156, a second gas line 18L, a circulation line 19L, and a valve driving portion 500.

The storage tank 411 is housed in the fluid cabinet 410. The storage tank 411 stores the chemical liquid. The circulation line 19L circulates the chemical liquid stored in the storage tank 411. Specifically, the circulation line 19L has a circulation piping 191, a circulation pump 192, and a circulation filter 193.

The circulation piping 191 is a tubular member through which the processing liquid (liquid) flows. The circulation piping 191 is disposed outside the chamber 301. Specifically, one end and the other end of the circulation piping 191 are connected to the storage tank 411. The circulation piping 191 makes the chemical liquid (fluid) to be supplied to the substrate processing portion 300 flow. A portion of the circulation piping 191 is housed in the fluid cabinet 410. The other portion of the circulation piping 191 is housed in the fluid box 420. In the present preferred embodiment, the inner virgin material piping 2a is used for the circulation piping 191. The circulation piping 191 is an example of the "extra-chamber piping."

The circulation pump 192 is interposed in the circulation piping 191. The circulation pump 192 is housed in the fluid cabinet 410. The circulation pump 192 feeds the chemical liquid such that the chemical liquid flows in the circulation piping 191 from the one end toward the other end of the circulation piping 191. As a result, the chemical liquid circulates in the circulation piping 191 via the storage tank 411. The circulation pump 192 is controlled by the controller 400 (the controlling portion 401).

The circulation filter 193 is interposed in the circulation piping 191. The circulation filter 193 is housed in the fluid cabinet 410. The circulation filter 193 removes foreign matter from the chemical liquid flowing in the circulation piping 191.

The recovery tank 156 is housed in the fluid cabinet 410. The recovery tank 156 stores the chemical liquid recovered by the recovery line 15L. The recovery line 15L makes the chemical liquid recovered from the liquid receiving portion 7 flow to the storage tank 411 via the recovery tank 156. Specifically, the recovery line 15L further has a third recovery piping 153, a recovery filter 154, and a recovery pump 155. The inner virgin material piping 2a is used for the third recovery piping 153. The third recovery piping 153 is an example of the "extra-chamber recovery piping."

The recovery filter 154 is interposed in the second recovery piping 152. The recovery filter 154 removes foreign matter from the chemical liquid flowing in the second recovery piping 152. The recovery filter 154 is housed, for example, in the fluid cabinet 410.

A downstream end of the second recovery piping 152 is connected to the recovery tank 156. Therefore, the second recovery piping 152 makes the chemical liquid expelled from the substrate W flow to the recovery tank 156.

The third recovery piping 153 is housed in the fluid cabinet 410. One end of the third recovery piping 153 is connected to the recovery tank 156. The other end of the third recovery piping 153 is connected to the storage tank 411.

The recovery pump 155 is housed in the fluid cabinet 410. The recovery pump 155 is interposed in the third recovery piping 153. The recovery pump 155 feeds the chemical liquid such that the chemical liquid flows in the third recovery piping 153 from the one end toward the other end of the third recovery piping 153. As a result, the chemical liquid is recovered in the storage tank 411. The recovery pump 155 is controlled by the controller 400 (the controlling portion 401).

As illustrated in FIG. 5, one end (the downstream end) of the first chemical liquid piping 111 is connected to the second chemical liquid piping 112, and the other end (an upstream end) of the first chemical liquid piping 111 is connected to the circulation piping 191. When the first opening-closing valve 113 is opened, the chemical liquid flowing into the first chemical liquid piping 111 from the circulation piping 191 is supplied to the first nozzle 5 via the second chemical liquid piping 112. As a result, the chemical liquid is discharged from the first nozzle 5. It is noted that the first nozzle 5 may be constituted of an end portion of the second chemical liquid piping 112.

In the present preferred embodiment, the actuator of the first opening-closing valve 113 is a pneumatic actuator. The second gas line 18L supplies air to the actuator of the first opening-closing valve 113. The valve driving portion 500 changes the pressure of the air supplied to the actuator of the first opening-closing valve 113 via the second gas line 18L to open and close the first opening-closing valve 113. The valve driving portion 500 is controlled by the controller 400 (the controlling portion 401). The valve driving portion 500 is, for example, a speed controller.

The second gas line 18L has a third gas piping 181. The third gas piping 181 is a tubular member through which air (gas) flows. In the present preferred embodiment, the recycled material piping 2d is used for the third gas piping 181. A portion of the third gas piping 181 is disposed inside the fluid box 420.

As described with reference to FIG. 5, according to the present preferred embodiment, the inner virgin material piping 2a is used for the circulation piping 191. Therefore, as compared with a case where the inner recycled material piping 2b or the recycled material piping 2d are used for the circulation piping 191, it becomes less likely that the number of particles on the substrate W increases.

Also, according to the present preferred embodiment, since the inner virgin material piping 2a is used for the circulation piping 191, it is possible to reduce the amount of the virgin material of fluororesin used in the substrate processing apparatus 100, as compared with a case where the virgin material piping 2c is used for the circulation piping 191. Thus, it is possible to save environmental resources.

Also, according to the present preferred embodiment, the recycled material piping 2d is used for the third gas piping 181. Therefore, the amount of the virgin material of fluororesin used in the substrate processing apparatus 100 can be reduced, as compared with a case where the virgin material piping 2c is used for the third gas piping 181. Thus, it is possible to save environmental resources.

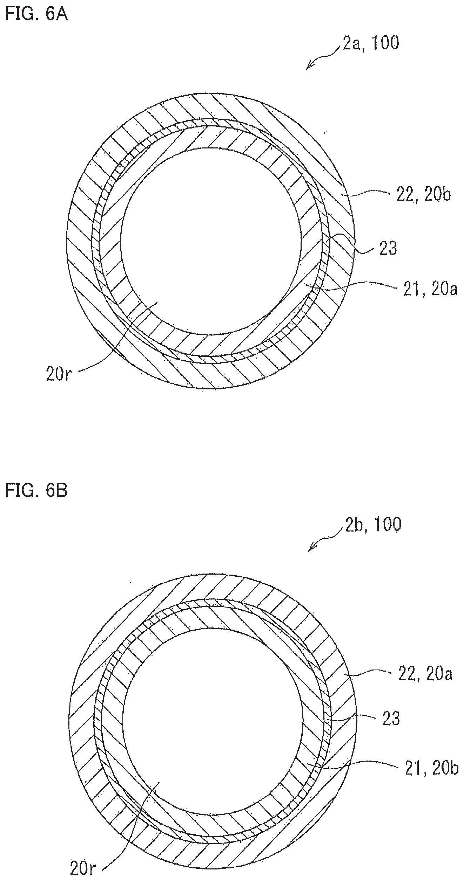

Next, with reference to FIG. 6A and FIG. 6B, modification examples of the inner virgin material piping 2a and the inner recycled material piping 2b shall be described. FIG. 6A is a view illustrating a modification example of the inner virgin material piping 2a. FIG. 6B is a view illustrating a modification example of the inner recycled material piping 2b.

As illustrated in FIG. 6A, the inner virgin material piping 2a may further have a barrier layer 23. The barrier layer 23 is formed between the inner layer 21 and the outer layer 22. The barrier layer 23 contains resin of a material through which a gas is less likely to permeate, as compared with the inner layer 21 and the outer layer 22. Therefore, by providing the barrier layer 23, it becomes even less likely that a gas in the flow passage 20r leaks to the outside of the inner virgin material piping 2a.

Similarly, the inner recycled material piping 2b may further have the barrier layer 23 (FIG. 6B). By providing the barrier layer 23, it becomes even less likely that a gas in the flow passage 20r leaks to the outside of the inner recycled material piping 2b.

The preferred embodiment of the present invention has been described above with reference to the drawings (FIG. 1 to FIG. 6B). According to the present preferred embodiment, the piping containing the recycled material 20b of fluororesin can be used for the piping of the substrate processing apparatus 100. Therefore, it is possible to save environmental resources.

It is noted that the present invention is not limited to the preferred embodiments described above and can be implemented in various modes within a scope not deviating from its gist. Also, it is possible to modify, as appropriate, the plurality of constituent elements disclosed in the preferred embodiments described above. For example, a certain constituent element among all constituent elements of a certain preferred embodiment may be added to the constituent elements of another preferred embodiment or some constituent elements among all constituent elements of a certain preferred embodiment may be deleted from the preferred embodiment.

The drawings mainly illustrate the respective constituent elements schematically to facilitate understanding of the invention and there are cases where thicknesses, lengths, numbers, intervals, etc., of the respective constituent elements illustrated differ from actuality due to convenience of drawing preparation. Also, the arrangements of the respective constituent elements indicated in the preferred embodiments described above are but an example, are not restricted in particular, and can obviously be changed variously within a scope of practically not deviating from the effects of the present invention.

For example, although in the embodiments described with reference to FIG. 1 to FIG. 6B, the virgin material piping 2c is a tubular member consisting of one layer of fluororesin, the virgin material piping 2c is not restricted in particular as long as at least the inner surface and the outer surface of which are constituted of the virgin material 20a of fluororesin. For example, the virgin material piping 2c may have a layer consisting of the recycled material 20b of fluororesin between the inner surface and the outer surface instead. For example, the virgin material piping 2c may be a tubular member consisting of three layers of fluororesin. Specifically, the virgin material piping 2c may have an inner layer containing the virgin material 20a of fluororesin, an intermediate layer containing the recycled material 20b of fluororesin, and an outer layer containing the virgin material 20a of fluororesin. Alternatively, the virgin material piping 2c may have a barrier layer between the inner surface and the outer surface or may have an intermediate layer on which an inner marking is performed.

Also, although in the embodiments described with reference to FIG. 1 to FIG. 6B, the recycled material piping 2d is a tubular member consisting of one layer of fluororesin, the recycled material piping 2d is not restricted in particular as long as at least the inner surface and the outer surface of which are constituted of the recycled material 20b of fluororesin. For example, the recycled material piping 2d may have, between the inner surface and the outer surface, a layer consisting of fluororesin obtained by mixing the virgin material 20a of fluororesin and the recycled material 20b of fluororesin. For example, the recycled material piping 2d may be a tubular member consisting of three layers of fluororesin. Specifically, the recycled material piping 2d may have an inner layer containing the recycled material 20b of fluororesin, an intermediate layer containing fluororesin obtained by mixing the virgin material 20a of fluororesin and the recycled material 20b of fluororesin, and an outer layer containing the recycled material 20b of fluororesin. Alternatively, the recycled material piping 2d may have a barrier layer between the inner surface and the outer surface or may have the intermediate layer on which an inner marking is performed.

Also, although in the preferred embodiments described with reference to FIG. 1 to FIG. 6B, a portion of the drain line 16L (the first drain piping 161) is disposed in the chamber 301, substantially an entire portion of the piping included in the drain line 16L may be disposed outside the chamber 301. For example, in a case where the first cup portion 712 is installed on a bottom wall of the chamber 301, substantially the entire portion of the piping included in the drain line 16L is disposed outside the chamber 301.

Also, although in the preferred embodiments described with reference to FIG. 1 to FIG. 6B, a portion of the recovery line 15L (the first recovery piping 151) is disposed inside the chamber 301, substantially an entire portion of the piping included in the recovery line 15L may be disposed outside the chamber 301. For example, in a case where the second cup portion 722 is installed on a bottom wall of the chamber 301, substantially the entire portion of the piping included in the recovery line 15L is disposed outside the chamber 301.

In the embodiments described with reference to FIG. 1 to FIG. 6B, at least one of either of coloring and marking may be performed on at least one of the inner virgin material piping 2a, the inner recycled material piping 2b, the virgin material piping 2c, and the recycled material piping 2d.

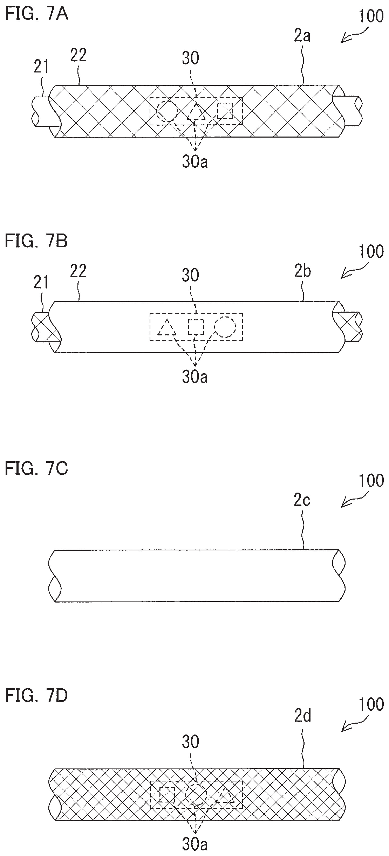

FIG. 7A, FIG. 7B, and FIG. 7D illustrate an example in which coloring and marking are performed on the inner virgin material piping 2a, the inner recycled material piping 2b, and the recycled material piping 2d, and FIG. 7C illustrates an example in which coloring and marking are not performed on the virgin material piping 2c In FIG. 7A, FIG. 7B, and FIG. 7D, cross-hatched regions each represent a colored translucent regions.

In a case where coloring is performed on the inner virgin material piping 2a, coloring may be performed on just one of either of the inner layer 21 or the outer layer 22 of the inner virgin material piping 2a, or coloring may be performed on both the inner layer 21 and the outer layer 22 of the inner virgin material piping 2a. The same applies to a case where coloring is performed on the inner recycled material piping 2b. In the examples illustrated in FIG. 7A and FIG. 7B, coloring is performed on the outer layer 22 of the inner virgin material piping 2a and the inner layer 21 of the inner recycled material piping 2b. A color of the inner layer 21 of the inner recycled material piping 2b can be visually confirmed through the outer layer 22 of the inner recycled material piping 2b.

In a case where coloring is performed on two or more of the inner virgin material piping 2a, the inner recycled material piping 2b, the virgin material piping 2c, and the recycled material piping 2d, the colors may be made different from each other. In this case, types or densities of colors may be made different from each other, or types and densities of colors may be made different from each other. FIG. 7A and FIG. 7D illustrate examples in which the types of color is the same as each other but the density of color is different from each other. In a case where marking is performed on two or more of the inner virgin material piping 2a, the inner recycled material piping 2b, the virgin material piping 2c, and the recycled material piping 2d, the external appearances of the markings may be made different as illustrated in FIG. 7A, FIG. 7B, and FIG. 7D.

By making at least one of presence or absence of coloring, presence or absence of a marking, a type of color, a density of color, and the external appearance of the marking different between the inner virgin material piping 2a, the inner recycled material piping 2b, the virgin material piping 2c, and the recycled material piping 2d, it is possible to visually determine which one is the inner virgin material piping 2a, the inner recycled material piping 2b, the virgin material piping 2c, and the recycled material piping 2d.

In the case where coloring is performed on the inner virgin material piping 2a, coloring may be performed on an entirety of the inner virgin material piping 2a, or coloring may be performed on just a portion of the inner virgin material piping 2a. The same is applied to the inner recycled material piping 2b, the virgin material piping 2c, and the recycled material piping 2d.

In the case where coloring is performed on the inner virgin material piping 2a, a colored portion of the inner virgin material piping 2a may be translucent or may be opaque. In the former case, a degree of transparency of the inner virgin material piping 2a may be a degree of transparency with which it is possible to visually identify whether or not a liquid is present in the inner virgin material piping 2a or may be a degree of transparency with which such visual identification is not possible. The same is applied to the inner recycled material piping 2b, the virgin material piping 2c, and the recycled material piping 2d.

In the case where the inner virgin material piping 2a is colored, a black coloring component different from fluororesin may be contained in the colored portion of the inner virgin material piping 2a. In this case, the inner virgin material piping 2a is colored black with a density corresponding to a concentration of the coloring component. In a case where the concentration of the coloring component is low, the inner virgin material piping 2a is colored gray (light black). The inner virgin material piping 2a may be colored black with a degree of transparency with which it is possible to visually identify whether or not a liquid is present in the recycled material piping 2a. The coloring component may be a substance such as blue other than black. The black coloring component may be carbon. In this case, the inner virgin material piping 2a can be colored without increasing contaminants such as a metal. The contents of this paragraph also apply to a case where at least one of the inner recycled material piping 2b, the virgin material piping 2c, and the recycled material piping 2d is colored.

In a case where marking is performed, at least one of the inner virgin material piping 2a, the inner recycled material piping 2b, the virgin material piping 2c, and the recycled material piping 2d includes a marking portion 30. The marking may include one or more marks 30a. The mark 30a may be any of a letter, a number, a symbol, a figure, and an emoji or may be other than these.

FIG. 7A, FIG. 7B, and FIG. 7D illustrate examples in which identification symbols including one or more marks 30a are provided on the inner virgin material piping 2a, the inner recycled material piping 2b, and the recycled material piping 2d. Broken-line rectangles in FIG. 7A, FIG. 7B, and FIG. 7D represent regions including the marking portion 30. The rectangle is an example of a boundary line surrounding the identification symbol. Such a boundary line may be a line that can be visually identified or may be a virtual line that does not actually exist. In the former case, the boundary line may or may not be a portion of the marking portion 30.

Figures of circles, triangles, and quadrilaterals in FIG. 7A, FIG. 7B, and FIG. 7D represent mutually different marks 30a. In the examples illustrated in FIG. 7A, FIG. 7B, and FIG. 7D, a sequential order of a plurality of the marks 30a constituting one identification symbol is different among the inner virgin material piping 2a, the inner recycled material piping 2b, and the recycled material piping 2d. Therefore, a difference in the marking portion 30 among the inner virgin material piping 2a, the inner recycled material piping 2b, and the recycled material piping 2d can be visually identified. Even when the colors of the inner virgin material piping 2a, the inner recycled material piping 2b, and the recycled material piping 2d are the same or similar, the inner virgin material piping 2a, the inner recycled material piping 2b, and the recycled material piping 2d can be identified based on the difference in the marking portion 30.

In a case where marking is performed on the inner virgin material piping 2a, the marking portion 30 may be disposed on the outer surface of the inner virgin material piping 2a or may be disposed between the inner surface of the inner virgin material piping 2a and the outer surface of the inner virgin material piping 2a. The same applies to a case where marking is performed on at least one of the inner recycled material piping 2b, the virgin material piping 2c, and the recycled material piping 2d.

The marking portion 30 disposed between the inner surface and the outer surface is referred to as an inner marking. as long as the inner markings can be visually identified through the outer surface, the inner marking may have or does not have to have a portion colored in a color different from the outer surface. In a case where the marking portion 30 is the inner marking, the marking portion 30 may be formed by laser processing. For example, the marking portion 30 may be formed by adjusting a focal point of laser light between the inner surface and the outer surface during laser processing.

Also, although in the preferred embodiments described with reference to FIG. 1 to FIG. 6B, the spin chuck 3 is a clamping type chuck, the spin chuck 3 is not restricted to the clamping type chuck. For example, the spin chuck 3 may be a vacuum type chuck.

Also, although in the preferred embodiments described with reference to FIG. 1 to FIG. 6B, the substrate processing apparatus 100 is a single substrate processing type apparatus, the substrate processing apparatus 100 may be a batch type apparatus.

Also, although in the preferred embodiments described with reference to FIG. 1 to FIG. 6B, the substrate processing apparatus 100 is an etching apparatus or a cleaning apparatus, the substrate processing apparatus 100 is not restricted in particular as long as it is an apparatus that processes a substrate. For example, the substrate processing apparatus 100 may be a coating apparatus, a developing apparatus, an exposure apparatus, a baking apparatus, or a film forming apparatus.

This application claims priority based on Japanese Patent Application No. 2023-158164 filed on September 22, 2023 and Japanese Patent Application No. 2024-110865 filed on July 10, 2024, and the entire contents of these applications are hereby incorporated herein by reference.

## Claims

1. A substrate processing apparatus that processes a substrate, the substrate processing apparatus comprising a plurality of pipings that make a fluid flow, wherein
the plurality of pipings include at least one inner virgin material piping having an inner layer containing a virgin material of fluororesin and an outer layer formed on an outer side of the inner layer,
the outer layer contains a recycled material of fluororesin, and
the fluid flows on an inner side of the inner layer.

2. The substrate processing apparatus according to claim 1, further comprising a substrate processing portion that executes substrate processing on the substrate, wherein
the substrate processing portion has a chamber that houses the substrate,
the plurality of pipings include an extra-chamber piping which is disposed outside the chamber and makes the fluid to be supplied to the substrate processing portion flow, and
the extra-chamber piping includes the inner virgin material piping.

3. The substrate processing apparatus according to claim 2, further comprising a nozzle that is disposed inside the chamber and discharges the fluid in the chamber, wherein
the plurality of pipings include an intra-chamber supply piping which is disposed inside the chamber and makes the fluid to be supplied to the nozzle flow, and
the intra-chamber supply piping includes a virgin material piping at least an inner surface and an outer surface of which are constituted of a virgin material of fluororesin.

4. The substrate processing apparatus according to any one of claims 1 to 3, further comprising:
a substrate processing portion that executes substrate processing on the substrate; and
a fluid cabinet that houses a liquid to be supplied to the substrate processing portion, wherein
the substrate processing portion has a chamber that houses the substrate,
the plurality of pipings include a recovery piping by which the liquid expelled from the substrate processing portion is recovered to the fluid cabinet,
the recovery piping includes an extra-chamber recovery piping that is disposed outside the chamber, and
the extra-chamber recovery piping includes the inner virgin material piping.

5. The substrate processing apparatus according to claim 4, wherein
the recovery piping includes an intra-chamber recovery piping that is disposed inside the chamber, and
the intra-chamber recovery piping includes a virgin material piping at least an inner surface and an outer surface of which are constituted of a virgin material of fluororesin.

6. The substrate processing apparatus according to any one of claims 1 to 3, wherein the inner virgin material piping further has a barrier layer that is formed between the inner layer and the outer layer.

7. The substrate processing apparatus according to any one of claims 1 to 3, wherein a thickness of the inner layer is less than a thickness of the outer layer.

8. The substrate processing apparatus according to any one of claims 1 to 3, wherein coloring is performed on the inner virgin material piping.

9. The substrate processing apparatus according to claim 8, wherein
the plurality of pipings include a virgin material piping at least an inner surface and an outer surface of which are constituted of a virgin material of fluororesin, and
the virgin material piping is different in color from the inner virgin material piping.

10. A substrate processing apparatus that processes a substrate, the substrate processing apparatus comprising a plurality of pipings that make a fluid flow, wherein
the plurality of pipings include at least one inner recycled material piping having an inner layer containing a recycled material of fluororesin and an outer layer formed on an outer side of the inner layer,
the outer layer contains a virgin material of fluororesin, and
the fluid flows on an inner side of the inner layer.

11. The substrate processing apparatus according to claim 10, further comprising a substrate processing portion that executes substrate processing on the substrate, wherein
the substrate processing portion has a chamber that houses the substrate,
the plurality of pipings include a drain piping through which the fluid is expelled from the substrate processing portion,
the drain piping includes an intra-chamber drain piping that is disposed inside the chamber, and
the intra-chamber drain piping includes the inner recycled material piping.

12. The substrate processing apparatus according to claim 11, wherein
the drain piping includes an extra-chamber drain piping that is disposed outside the chamber, and
the extra-chamber drain piping includes a recycled material piping constituted of a recycled material of fluororesin.

13. The substrate processing apparatus according to any one of claims 10 to 12, wherein the inner recycled material piping further has a barrier layer that is formed between the inner layer and the outer layer.

14. The substrate processing apparatus according to any one of claims 10 to 12, wherein a thickness of the outer layer is less than a thickness of the inner layer.

15. The substrate processing apparatus according to any one of claims 10 to 12, wherein coloring is performed on the inner recycled material piping.

16. The substrate processing apparatus according to claim 15, wherein
the plurality of pipings include a recycled material piping that is constituted of a recycled material of fluororesin,
coloring is performed on the recycled material piping, and
marking is performed on at least one of either of the inner recycled material piping and the recycled material piping.
